# EUROPEAN PATENT APPLICATION

(11) **EP 0 592 671 A1**
(43) Date of publication of application: **20.04.1994**
(21) Application number: 92914382.4
(22) Date of filing: 02.07.1992
(51) Int. Cl.: H01L 21/304

(54) **SILICON WAFER AND ITS CLEANING METHOD**

(30) Priority: 02.07.1991 JP 188148/91
(71) Applicant: OHMI, Tadahiro, Sendai-shi Miyagi-ken 980 (JP)
(72) Inventor: OHMI, Tadahiro, Sendai-shi Miyagi-ken 980 (JP)
(74) Representative: Weitzel, Wolfgang, Dr.-Ing. Patentanwalt
(86) International application number: JP9200839
(87) International publication number: WO9301615

(57) **Abstract**

A silicon wafer of a diameter larger than eight inches, whose surfaces are not roughed by cleaning with NH₄OH-H₂O₂, and on which devices of higher performances can be fabricated. A thermal oxidation film is formed on the entire surface of a silicon wafer of a diameter larger than eight inches which is prepared by slicing an ingot made through a pulling method. After removing all the thermal oxidation film of the silicon wafer, the whole surface of the wafer is cleaned with NH₄OH-H₂O₂.

## Description

### Technical Field

The present invention relates to a silicon wafer for use in LSI manufacturing, and in particular, relates to a silicon wafer having little empty lattice on the wafer surface thereof.

### Background Art

In accordance with the progress in the shift to highly integrated and high performance LSI, demands have been greatly increasing for silicon wafers having few defects, and which have high smoothness with few surface irregularities. In LSI manufacturing processes, after the arrival of the silicon wafer, the organic materials, metals, particles, or the like which adhere to the silicon wafer are first cleaned away using various chemicals such as, for example, H₂SO₄-H₂O₂, NH₄OH-H₂O₂, HCl-H₂O₂, and the like. Furthermore, in the process of forming the elements, as well, in order to prevent the worsening of element characteristics as a result of the above organic materials, metals, particles, or the like, the washing described above is conducted prior to, for example, diffusion or the like.

The present inventors have discovered the following with respect to the relationship among the washing method, the state of the wafer surface after washing, and the element characteristics, as a result of intensive research with respect to washing methods of silicon wafers.

A silicon monocrystal produced by the pull method was sliced, and the surface roughnesses Ra of the CZ silicon wafers which were obtained by mirror polishing the slices were measured by means of a scanning tunnelling microscope, and were found to be within approximately a range of 0.1 -0.4 nanometers. Here, surface roughness Ra represents the average central surface roughness, and represents an averaging of the absolute values of the size of the imperfections from the center line along which imperfections were averaged.

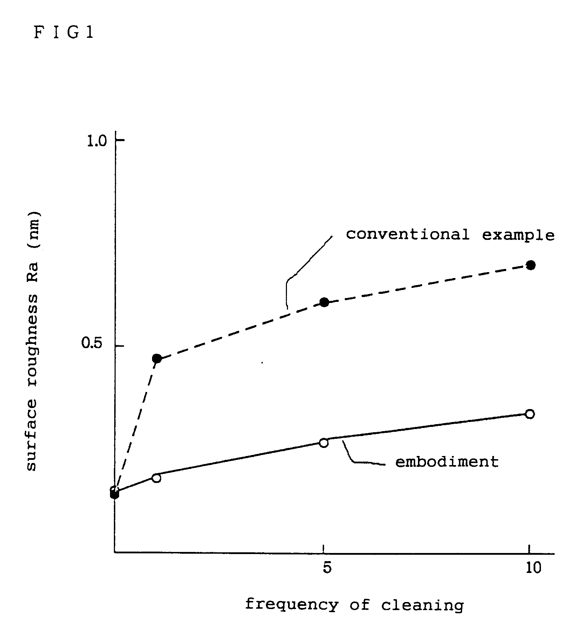

When washed with the above NH₄OH-H₂O₂, such a wafer has an increased surface roughness Ra in comparison with an epitaxial wafer, and when the washing is repeated, the surface roughness increases greatly. For example, as shown by the dotted line in Fig. 1, when a wafer having a surface roughness Ra of 0.1 nanometers is washed with NH₄OH-H₂O₂, Ra becomes 0.4 nanometers or greater. When this washing is repeated 10 times, surface roughness increases to a level of 0.6 - 0.7 nanometers. As a result, it was learned that the characteristics of the elements thus formed, for example, the dielectric breakdown voltage of the insulating film or the MOS characteristics or the like, were inferior in comparison with the case in which formation was conducted on an epitaxial wafer. This trend increased strikingly as the diameter of the wafer increased, and in particular in wafers having a diameter of 8 inches or more, a problem was caused in that the device characteristics and reliability declined dramatically.

The roughening of the surface of the silicon wafer as a result of NH₄OH-H₂O₂ washing is thought by the present inventors to take place as a result of the interpolation of the empty lattice of the silicon. That is to say, in the first washing, the silicon surface is subjected to etching on a level of approximately 80 angstroms; however, when an empty lattice exists, isotropic etching cannot be conducted, and anisotropic acid etching occurs as a result of the empty lattice, so that the periphery of the empty lattice is etched to a greater degree, and it is thought that as a result, the surface becomes rough. The reason that the surface roughness of the CZ wafer becomes great is that there are many empty lattices in the crystal. In particular, there is a high empty lattice density in wafers having a diameter of 8 inches or more, and thus the surface roughness becomes particularly pronounced. When the diameter increases, it is thought that nonuniform heat at the time of pulling and warping due to gravity and the like are the cause for the increase in empty lattices; however, the true cause is unknown.

The present invention has as an object thereof to provide a silicon wafer which is capable of suppressing the surface roughness of the wafer resulting from NH₄OH-H₂O₂ washing with respect to large diameter wafers having a diameter of 8 inches or more, and which is capable of forming high performance elements.

### Disclosure of the Invention

A first feature of the present invention resides in a silicon wafer, characterized in that a thermal oxide film is formed over the entirety of the surface of a silicon wafer having a diameter of 8 inches or more which is obtained by the slicing of an ingot produced by means of the pull method.

A second feature of the present invention resides in a wafer cleaning method, characterized in that after a thermal oxide film is removed from the silicon wafer of the first feature, the entire surface of the wafer is washed with NH₄OH-H₂O₂.

### (Function)

Hereinbelow, the functions of the present invention will be explained.

The silicon wafers of the present invention are sliced from an ingot produced by means of the pull method, are subjected to mirror polishing, and are washed, and then these are heated and oxidized in an oxidizing atmosphere of, for example, an oxidation furnace or the like, and a thermal oxide film is thus formed on the surface thereof.

In this thermal oxidation treatment, it is possible to employ either dry oxidation or wet oxidation, in which oxidation is carried out in an atmosphere containing moisture. As a result of this oxidizing processing, the empty lattice density of the silicon surface layer is reduced in comparison with a bulk empty lattice density, and the surface layer becomes a more acceptable crystal. From the point of view of stopping the surface roughness as a result of NH₄OH-H₂O₂ washing, it is desirable that the empty lattice density of the surface layer be reduced by a factor of 10 or more in comparison with the bulk. By combining temperature, oxidizing gas or moisture concentration, flow rate, time period, and the like, various conditions can be selected for the thermal oxidizing treatment; however, conditions which produce an oxide film thickness of 0.7 micrometers are desirable. Such a 0.7 micrometer thermal oxide film may be produced, for example, by means of wet oxidizing at a temperature of 1000°C and for a period of 4 hours. Furthermore, dry oxidizing may also be employed. By forming a thermal oxide film of 0.7 micrometers or more, the effect of preventing the surface roughening produced by contact with a NH₄OH-H₂O₂ solution is further increased.

On the other hand, in order to, for example, improve the device characteristics of an MOS transistor or the like, it is desirable that the thickness of the surface layer in which the above empty lattice density is reduced be 800 angstroms or greater.

After removing the above thermal oxide film by etching, even if NH₄OH-H₂O₂ washing is conducted, the roughening of the surface will be suppressed, and when elements are produced on a wafer which has been subjected to this type of treatment, the element characteristics, such as, for example, the dielectric breakdown voltage, the MOS characteristics, and the like, will be greatly improved.

The reason for this is that, as a result of the formation of an oxide film on the wafer surface, the intralattice silicon atoms generated by the thermal oxidation enter the vacancies which are produced during the pulling of the silicon monocrystal, and fill the empty lattice, so that as a result, there are few vacancies, and a more complete crystal is formed. Accordingly, it is thought that even if such a crystal is brought into contact with an NH₄OH-H₂O₂ solution, there is little acceleration of the etching of the silicon by the empty lattice, so that the roughening of the surface by washing is suppressed.

Furthermore, the oxide film may be removed from the silicon wafer after the formation thereof by means of etching; however, if thermal oxide film remains on the silicon wafer, it is possible to prevent the occurrence of damage to the wafer resulting from collision with cases and the like during silicon wafer transportation, and to prevent the adhesion of particles, such as debris and the like, to the silicon surface.

### Brief Description of the Diagrams

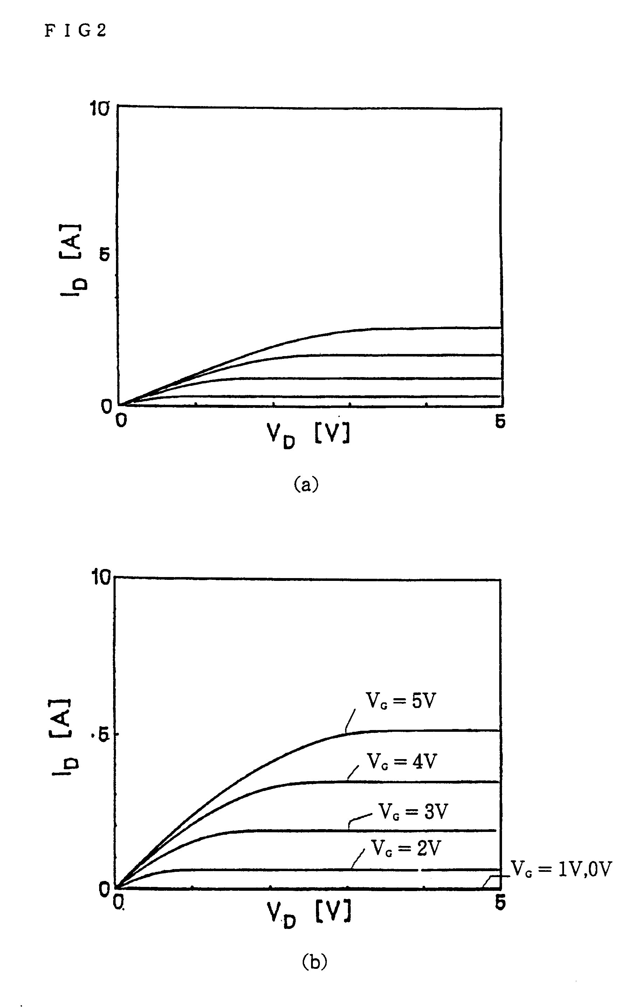

Figure 1 is a graph showing the relationship between NH₄OH-H₂O₂ washing and silicon wafer surface roughness Ra. Figure 2 shows graphs indicating the current (I_{D}) - voltage (V_{D}) characteristics of an n-channel MOS; (a) indicates a conventional example, while (b) indicates that of the embodiment.

### Best Mode for the Execution of the Invention

### (Embodiment 1)

A CZ silicon wafer having a diameter of 8 inches was placed in an oxidizing furnace at a temperature of 1000°C, and was heated for a period of 4 hours under a gas flow of 1 L/min of H₂ and 1 L/min of O₂, and a thermal oxide film of 0.7 micrometers was formed on the wafer surface.

Next, the thermal oxide film was subjected to etching using a hydrofluoric acid buffer solution (NH₄OH + HF + H₂O), and was washed for a period of 10 minutes in an NH₄OH-H₂O₂-H₂O (1:1:5) washing solution. The surface roughness Ra after washing was measured with a scanning tunneling microscope and the results thereof are shown in Figure 1. As a further comparative example, the surface roughness Ra of a conventional wafer, which was not subjected to thermal oxide film formation but which was subjected to NH₄OH-H₂O₂ washing, was measured in the same manner. The results thereof are also shown in Figure 1.

As shown in Figure 1, the conventional wafer, which was not subjected to thermal oxide film formation, had a surface roughness of 0.15 micrometers prior to washing, and the surface roughness increased to 0.45 micrometers after 10 minutes of washing, and when washing was repeated 10 times, the surface roughness increased to 0.65 micrometers. However, the wafer of the present embodiment had a surface roughness of 0.2 nanometers after one washing, thus representing almost no change in surface roughness, and even after 10 washings, the surface roughness was 0.35 micrometers, so that the approximate surface state after wafer polishing was maintained.

In one NH₄OH-H₂O₂ washing, roughly 80 angstroms of the Si is etched, so that the reason that the roughness did not increase after 10 washings was that in the 800 angstrom surface layer, the empty lattice concentration had been sufficiently reduced. That is to say, in the present embodiment, the thickness of the surface layer in which the empty lattice density is reduced is 800 angstroms or more, so that no adverse effects will be exerted on the devices formed on the wafer surface. Furthermore, it became clear that the density was reduced to 1/10th that of bulk density or less. This was confirmed by results of measurements of the wafers of the present embodiment and the conventional wafers using the DLTS method (Deep Level Transient Spectroscopy). Next, a 9.8 nanometer thermal oxide film was formed on a wafer which had been subjected to one washing, and on this, an Al electrode was formed, and the dielectric breakdown strength of the oxide film, and the amount of charge Q_{BD} needed to cause dielectric breakdown in an electrical field of 9.5 MV/cm, were measured. The results thereof are shown in Table 1.

**TABLE 1**

| | Dielectric Strength(MV/cm) | Q_{BD}(coulombs/cm²) |
|---|---|---|
| Wafer of the Embodiment | 11.5 | 3.5 X 10² |
| Conventional Wafer | 10.5 | 6 X 10¹ |

As is clear from the Table, the thermal oxide film which is produced on the silicon wafer of the present embodiment exhibits extremely desirable characteristics as an insulating film in comparison with the conventional silicon wafer.

Furthermore, using a silicon wafer of the present embodiment on which a 0.7 micrometer thermal oxide film had been formed, and a conventional silicon wafer, the following type of n-channel MOS was formed.

| | |
|---|---|
| Channel length | 10 micrometers |
| Channel width | 100 micrometers |
| Gate oxide film thickness | 10 nanometers |

The current (I_{D}) - voltage (V_{D}) characteristics of the MOS thus produced are shown in Figure 2. Furthermore, the electron mobility determined from the I_{D} - gate voltage V_{D} characteristics when V_{D} = 0.05V is shown in Table 2.

**TABLE 2**

| | Electron Mobility (cm²/V·sec) |
|---|---|
| Wafer of the Embodiment | 375 |
| Conventional Wafer | 260 |

As is clear from Figure 2 and Table 2, by means of using a silicon wafer in accordance with the present embodiment, it was possible to realize an MOS transistor having superior characteristics. Furthermore, the obtainable value for electron mobility was close to the bulk value (400 cm²/V·sec), and this indicates the possibility of the production of high-performance devices which were not conventionally available.

In wet oxidation, the speed of oxidation is high, and as oxidation proceeds, a large amount of intralattice atoms are formed at the Si-SiO₂ boundary, and these are thought to disperse in the bulk interior, and fill the empty lattice. Accordingly, when wet oxidation is employed, the empty lattice can be effectively eliminated. Furthermore, a SiO₂ film having a thickness of 0.7 micrometers can be formed in the short time of 4 hours, so that this process can be shortened. However, similar effects can be obtained if dry oxidation is employed, so that the present invention is not necessarily limited to wet oxidation.

Furthermore, heretofore discussion has been conducted with respect to the formation of an oxide film having a thickness of 0.7 micrometers or more; however, it has been learned that if the wafer is one having little empty lattice, sufficient effects will be obtained even with oxide films having a thickness of less than 0.7 micrometers. Accordingly, it is obvious that the use of oxide films thinner than 0.7 micrometers is acceptable; however, in consideration of variation in empty lattice density of the wafers, by the formation of an oxide film having a thickness of 0.7 micrometers or more, stable effects can be obtained.

### Industrial Applicability

In accordance with the present invention, it is possible to suppress the roughening of the surface caused by washing with NH₄OH-H₂O₂, so that it becomes possible to provide a silicon wafer for use in high-performance elements having, for example, a thin gate oxide film or capacitor. Furthermore, it has become possible to prevent damage to the silicon wafer resulting from collision with cases and the like during transport, and to prevent the adhesion of particles such as debris or the like to the silicon.

## Claims

1. A silicon wafer, wherein a thermal oxide film is formed over the entire surface of a silicon wafer having a diameter of eight inches or more obtained by slicing an ingot produced by a pull method.

2. A silicon wafer in accordance with Claim 1, wherein the thickness of said thermal oxide film is 0.7 micrometers or more.

3. A silicon wafer in accordance with one of Claims 1 and 2, wherein said thermal oxide film is formed in an atmosphere containing H₂O.

4. A silicon wafer in accordance with one of Claims 1 through 3, wherein the thickness of a surface layer, in which the empty lattice density is less than 1/10 that of the empty lattice density of a bulk portion of said silicon wafer, is 800 angstroms or more.

5. A wafer cleaning method, wherein the thermal oxide film of a silicon wafer in accordance with one of Claims 1 through 4 is completely removed, and the entire surface of the wafer is washed with NH₄OH-H₂O₂.
